# EUROPEAN PATENT SPECIFICATION

(11) **EP 0 502 710 B1**
(45) Date of publication and mention of the grant of the patent: **17.07.1996**
(21) Application number: 92301854.3
(22) Date of filing: 04.03.1992
(51) Int. Cl.: H01L 23/02

(54) **Flexible film semiconductor package**
Halbleiteraufbau mit flexibler Trägerfolie
Emballage à film flexible pour semi-conducteur

(30) Priority: 04.03.1991 US 664170
(43) Date of publication of application: 09.09.1992
(73) Proprietor: TEXAS INSTRUMENTS INCORPORATED, Dallas Texas 75265 (US)
(72) Inventor: McLellan, Neil R., Garland, Texas 75044 (US)
(74) Representative: Blanco White, Henry Nicholas

(56) References cited:
- EP-A- 0 361 985
- WO-A-90/05379
- DE-A- 4 002 538
- US-A- 4 007 479
- PATENT ABSTRACTS OF JAPAN vol. 10, no. 179 (E-414)(2235), 24 June 1986 ; & JP-A-61 27 663

## Description

This invention relates to semiconductor devices, and more particularly to a package using a thin flexible film for the packaging material.

The demand for ever higher circuit board density has resulted in small size semiconductors devices having a low profile. Board space considerations have traditionally been viewed from a two dimensional perspective, and the motivation for thin packaging has been a secondary issue. However, with the electronics industry looking at thin packaging to address density issues associated with products like memory cards, smart cards, emulator cards, package thickness is a critical factor.

Prior art packages include conventional packaging such as National Semiconductor's TapePak™, Tape Automated Bonding (TAB), Dual In-line Pin (DIP) packages, and Small Outline Packages (SOPs). TAB packaging uses a liquid plastic to encapsulate the semiconductor chip. Conventional prior art packages use wire bonds to connect the chip to a leadframe. TapePak^{TM} has connections along four sides of the package.

JP-A 61-27663 discloses a semiconductor package in which a semiconductor chip and its attached wiring are enclosed between two flexible films, which are attached to each other round the periphery by an adhesive agent.

WO-A 90/05379, on which the preambles of claims 1 and 7 are based, discloses a similar package for use in conditions where high accelerations occur, in which the peripheral portions of the two films are clamped between the two halves of an annular clamping frame.

The invention provides a thin film semiconductor device package, comprising: a semiconductor device; a plurality of leads having a first end attached to the semiconductor device at contacts, a lead part adjacent to said first ends and extending away from the semiconductor device and a second end; a first thin flexible film on one side of the semiconductor device and leads; and a second thin flexible film on the side of the semiconductor device and leads opposite said first thin flexible film; wherein said first and second thin films are bonded to each other between said lead parts, and bonded thereto to form a sealed thin film package, with said second ends of said leads extending from said thin film package; characterised in that a support ring is mounted on said lead parts and supports that one of the thin flexible films which is on the same side of the contacts in the region where the first lead ends are attached to the semiconductor device.

The invention also provides a method of making a thin film packaged semiconductor device comprising the steps of: tab bond interconnecting first ends of a plurality of leads on a lead frame to contacts of a bumped semiconductor device, said leads having lead parts adjacent to said first ends and extending away from the semiconductor device and further having second lead ends; applying first and second sheets of thin flexible film material to opposite surfaces of the semiconductor device and the leads; and bonding the first and second sheets of thin flexible film material to each other and to said lead parts to form a sealed package enclosing the semiconductor device and said lead parts, whereby said second lead ends extend from said thin film package; characterised in that it includes the step of mounting a support ring on the said lead parts prior to said step of applying the sheets of thin flexible film material.

The film hermetically seals the device from the environment, gives mechanical strength to the device, provides a low profile and is a low weight device. The package can be produced at low cost when compared with standard packaging techniques.

The semiconductor device may be a semiconductor die or integrated circuit having "bump" contacts in either a "chip-up" or "chip-down" configuration. Offset leads may be used in conjunction with the support ring to minimize stress on the bump-lead interface.

In the drawings:
Figure 1 is a side view, in section, of one form of semiconductor device package;
Figure 2 is a top view of the package of Figure 1;
Figure 3 is a side view of a second form of package, with the semiconductor die contact side up; and
Figure 4 is a side view of one form of package according to the invention with offset leads and a support ring.

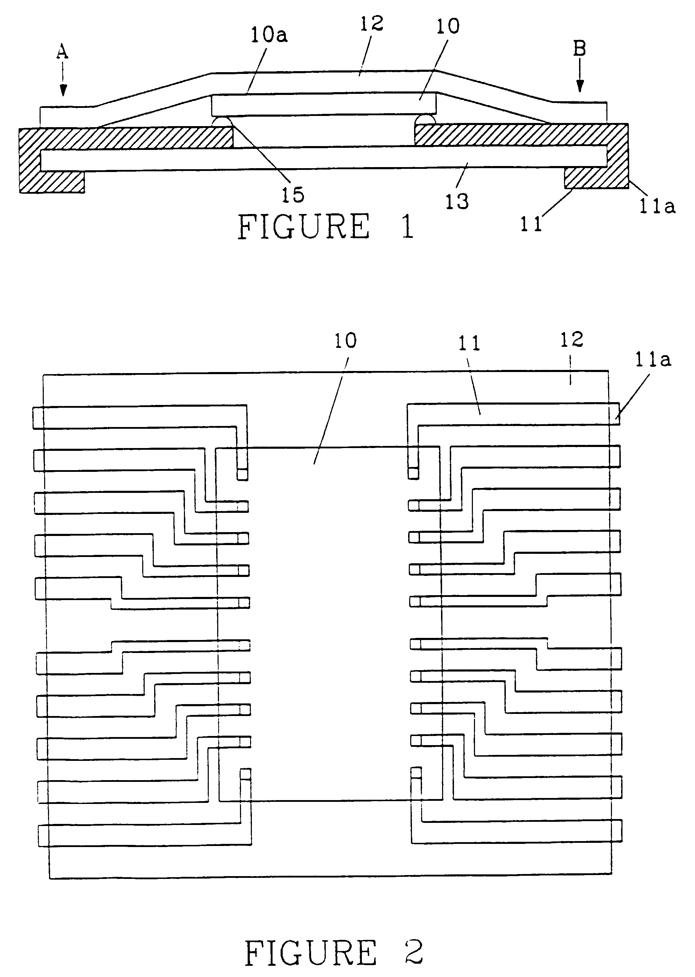

Figure 1 illustrates a thin film package semiconductor device. The semiconductor die 10 has a plurality of bump contacts 15 thereon. Attached to each bump contact is a lead 11. The backside 10a of the semiconductor die is covered with a thin film of material which may be, for example, Ryton, a trademarked thin film flexible material manufacture by Phillips 66. This film may be obtained in sheets of 125 µm (0.005") thickness. The generic material is Polyphenylene Sulfide Resin. The under side of the semiconductor die and the leads 11 are also covered by the plastic film. An ultrasonic bond is made between the film and leads in the regions indicated by arrows A and B. Leads may optionally be folded around the bottom film as illustrated in Figure 1. The leads, in one embodiment, were made from a palladium plated leadframe.

Figure 2 is a top view of the device of Figure 1 illustrating the typical layout of leads on an integrated circuit device. Leads 11 are arrayed around the device 10 and extend out the sides of the device. The plastic film covers the device and leads, except for the ends of the leads 11a which provide external electrical contact to the integrated circuit. The number of leads and arrangement of the leads is not a critical factor, but may be arrayed around the semiconductor device depending upon the device configuration.

The package is light weight, and, in one embodiment, is about 0.75mm (0.03") thick. This thin film package device is functional mechanically as well as electrically, and in most instances provide a cleaner and better sealed device than the standard epoxy molded device. No mechanical degradation has been observed during storage or solder dunk at 250° C. during lead solder coating.

The process flow for the package includes the steps of tab bonding the wafer to a lead frame or leads, placing the device and leads between two sheets of film and ultrasonically sealing the film around the leads. The film seals to itself between the leads and to the leads to form a hermetic seal. Sealing of the film may be done prior to separating a plurality of devices on a continuous strip of lead frame. After sealing, the device may be symbolized and then separated into individual devices prior to testing.

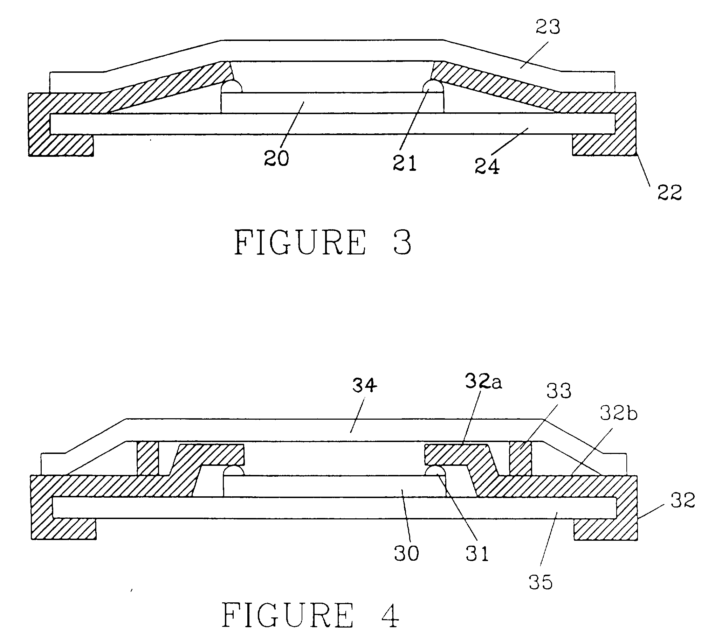

Figure 3 illustrates a second form of thin film package. The semiconductor device or integrated circuit 20 has a plurality of contacts 21 thereon. The leads 22 are bonded to the contacts and then angled downward to the plane of the semiconductor device. Thereafter, the top film 23 and bottom film 24 are sealed around the device, and to the leads 22.

Figure 4 shows an embodiment of the thin film package according to the invention. The semiconductor device 30 is mounted with the contact side up. Leads are connected to the contacts and then bent downwardly to lie in the plane of the semiconductor device. A support ring 33 of an insulating material is mounted on the part of the lead 32b that is in the plane of the semiconductor device, and extends above the part of the lead 32a bonded to contact 31. Plastic film 34 is applied over the contacts 32 and support ring 33, and a second sheet of film 35 is placed under the semiconductor device 30. Support ring 33 relieves and minimizes stress or pressure on the junction of contact 31 and lead end 32a. The use of the support ring can also be used on devices which are wire bonded. The ring may extend completely around the device or be located just in the area of the leads/contacts.

## Claims

1. A thin film semiconductor device package, comprising;
a semiconductor device (30);
a plurality of leads (32) having a first end (32a) attached to the semiconductor device (30) at contacts (31), a lead part (32b) adjacent to said first ends (32a) and extending away from the semiconductor device (30) and a second end;
a first thin flexible film (34) on one side of the semiconductor device (30) and leads (32); and
a second thin flexible film (35) on the side of the semiconductor device (30) and leads (32) opposite said first thin flexible film (34);
wherein said first and second thin films (34,35) are bonded to each other between said lead parts (32b), and bonded thereto to form a sealed thin film package, with said second ends of said leads (32) extending from said thin film package;
characterised in that a support ring (33) is mounted on said lead parts (32b) and supports that one of the thin flexible films (34) which is on the same side of the contacts (31) in the region where the first lead ends (32a) are attached to the semiconductor device (30).

2. The thin film package according to claim 1, wherein said second lead ends (32) fold back over a portion of the film package.

3. The thin film package according to any preceding claim, wherein said support ring (33) is of metal.

4. The thin film package according to any preceding claim, wherein the first and second thin flexible films (34,35) are of a polyphenylene sulfide resin.

5. The thin film package according to any preceding claim, wherein the first lead ends (32a) are connected to the semiconductor device (30) with a TAB bond.

6. A method of making a thin film packaged semiconductor device comprising the steps of:
TAB bond interconnecting first ends (32a) of a plurality of leads (32) on a lead frame to contacts (31) of a bumped semiconductor device (30), said leads (32) having lead parts (32b) adjacent to said first ends (32a) and extending away from the semiconductor device (30) and further having second lead ends;
applying first and second sheets of thin flexible film material (34,35) to opposite surfaces of the semiconductor device (30) and the leads (32); and
bonding the first and second sheets of thin flexible film material (34,35) to each other and to said lead parts (32b) to form a sealed package enclosing the semiconductor device (30) and said lead parts (32b), whereby said second lead ends extend from said thin film package;
characterised in that it includes the step of mounting a support ring (33) on the said lead parts (32b) prior to said step of applying the sheets of thin flexible film material (34,35).

7. The method according to claim 6, wherein said bonding is performed ultrasonically.

8. The method according to claim 6 or 7, wherein the applying step is performed before the leads (32) are separated from a continuous leadframe strip.

## Patentansprüche

1. Halbleiterbauelementgehäuse aus dünner Folie, umfassend:
ein Halbleiterbauelement (30);
mehrere Anschlußleiter (32) mit einem ersten Ende (32a), das an dem Halbleiterbauelement (30) an Kontakten (31) angebracht ist, einem Anschlußleiterteil (32b), der an die ersten Enden (32a) angrenzt und sich von dem Halbleiterbauelement (30) weg erstreckt, und einem zweiten Ende;
eine erste dünne flexible Folie (34) auf einer Seite des Halbleiterbauelements (30) und der Anschlußleiter (32); und
eine zweite dünne flexible Folie (35) auf der Seite des Halbleiterbauelements (30) und der Anschlußleiter (32), die der ersten dünnen Folie (34) gegenüberliegt;
bei dem die erste und die zweite dünne Folie (34,35) zwischen den Anschlußleiterteilen (32b) miteinander verbunden sind und mit diesen selbst verbunden sind, um ein abgeschlossenes Gehäuse aus dünner Folie zu bilden, wobei die zweiten Enden der Anschlußleiter (32) aus dem Gehäuse aus dünner Folie herausragen;
dadurch gekennzeichnet, daß auf den Anschlußleiterteilen (32b) ein Stützring befestigt ist und diejenige der dünnen flexiblen Folien (34), die auf derselben Seite der Kontakte (31) liegt, in dem Bereich stützt, wo die ersten Anschlußleiterenden (32a) an dem Halbleiterbauelement (30) angebracht sind.

2. Gehäuse aus dünner Folie nach Anspruch 1, bei dem die zweiten Anschlußleiterenden (32) um einen Teil des Gehäuses aus Folie gefaltet sind.

3. Gehäuse aus dünner Folie nach einem der vorhergehenden Ansprüche, bei dem der Stützring (33) aus Metall ist.

4. Gehäuse aus dünner Folie nach einem der vorhergehenden Ansprüche, bei dem die erste und die zweite dünne flexible Folie (34,35) aus Polyphenylensulfid-Harz sind.

5. Gehäuse aus dünner Folie nach einem der vorhergehenden Ansprüche, bei dem die ersten Anschlußleiterenden (32a) an das Halbleiterbauelement (30) mit einer TAB-Bondverbindung angeschlossen sind.

6. Verfahren zur Herstellung eines mit dünner Folie gekapselten Halbleiterbauelements, das die Schritte umfaßt:
Verbinden der ersten Enden (32a) von mehreren Anschlußleitern (32) an einem Leiterrahmen mit Kontakten (31) eines mit Bump-Kontakten versehenen Halbleiterbauelements (30) nach dem TAB-Bondverbindungsverfahren, wobei die Anschlußleiter (32) Anschlußleiterteile (32b) aufweisen, die an die ersten Enden (32a) angrenzen und sich von dem Halbleiterbauelement (30) weg erstrecken und darüberhinaus zweite Anschlußleiterenden aufweisen;
Anbringen erster und zweiter Bahnen aus dünnem flexiblem Folienmaterial (34,35) an entgegengesetzten Flächen des Halbleiterbauelements (30) und den Anschlußleitern (32); und
Verbinden der ersten und zweiten Bahnen aus dünner flexibler Folie (34,35) miteinander und mit den Anschlußleiterteilen (32b), um ein abgeschlossenes, das Halbleiterbauelement (30) und die Anschlußleiterteile (32b) einschließendes Gehäuse zu bilden, wobei die zweiten Anschlußleiterenden aus dem Gehäuse aus dünner Folie herausragen; dadurch gekennzeichnet, daß es den Schritt des Befestigens eines Stützrings (33) auf den Anschlußleiterteilen (32b) vor dem Schritt des Anbringens der Bahnen aus dünnem flexiblen Folienmaterial (34,35) enthält.

7. Verfahren nach Anspruch 6, bei dem das Bonden mit Ultraschall durchgeführt wird.

8. Verfahren nach Anspruch 6 oder 7, bei dem der Schritt des Anbringens durchgeführt wird, bevor die Anschlußleiter (32) von einem kontinuierlichen Leiterrahmenstreifen getrennt worden sind.

## Revendications

1. Emballage à film fin pour dispositif semi-conducteur, comprenant :
- un dispositif semi-conducteur (30);
- une pluralité de conducteurs (32) ayant une première extrémité (32a) fixée au dispositif semi-conducteur (30) à des contacts (31), une portion de conducteur (32b) adjacente auxdites premières extrémités (32a) et s'étendant à partir dudit dispositif semi-conducteur (30) et une seconde extrémité;
- un premier film flexible fin (34) sur un côté du dispositif semi-conducteur (30) et des conducteurs (32); et
- un second film flexible fin (35) du côté du dispositif semi-conducteur (30) et des conducteurs (32) opposé audit premier film flexible fin (34);
dans lequel lesdits premier et second films fins (34,35) sont reliés l'un à l'autre entre lesdites portions de conducteur (32b), et fixés à celles-ci pour former un emballage de film fin étanche, avec lesdites secondes extrémités desdits conducteurs (32) s'étendant à partir dudit emballage à film fin,
caractérisé en ce qu'une bague de support (33) est montée sur lesdites portions de conducteur (32b) et supporte celui desdits films flexibles fins (34) qui est du même côté que les contacts (31) dans la région où les premières extrémités de conducteur (32a) sont fixées au dispositif semi-conducteur (30).

2. Emballage selon la revendication 1, dans lequel lesdites secondes extrémités de conducteur (32) sont repliées sur une portion de l'emballage à film.

3. Emballage selon l'une quelconque des revendications précédentes, dans lequel ladite bague de support (33) est métallique.

4. Emballage selon l'une quelconque des revendications précédentes, dans lequel les premier et second films flexibles fins (34,35) sont en résine de polysulfure de phénylène.

5. Emballage selon l'une quelconque des revendications précédentes, dans lequel lesdites premières extrémités de conducteur (32a) sont connectées au dispositif semi-conducteur (30) par une liaison TAB.

6. Procédé pour réaliser un dispositif semi-conducteur emballé à film fin, comprenant les étapes de :
- interconnecter par une liaison TAB des premières extrémités (32a) d'une pluralité de conducteurs (32) sur une trame de conducteurs à des contacts (31) d'un dispositif semi-conducteur (30), lesdits conducteurs (32) ayant des portions de conducteur (32b) adjacentes auxdites premières extrémités (32a) et s'étendant à partir dudit dispositif semi-conducteur (30) et ayant en outre des secondes extrémités de conducteur;
- appliquer des première et seconde feuilles d'un matériau de film flexible fin (34,35) sur des surfaces opposées du dispositif semi-conducteur (30) et des conducteurs (32); et
- relier les première et seconde feuilles de matériau de film flexible fin (34,35) l'une à l'autre et auxdites portions de conducteur (32b) pour former un emballage étanche renfermant le dispositif semi-conducteur (30) et lesdites portions de conducteur (32b), de manière que lesdites secondes extrémités de conducteur s'étendent à partir dudit emballage de film fin;
caractérisé en ce qu'il comporte l'étape de monter une bague de support (33) sur lesdites portions de conducteur (32b) avant ladite étape d'application des feuilles de matériau de film flexible fin (34,35).

7. Procédé selon la revendication 6, dans lequel ladite liaison est réalisée par voie ultrasonore.

8. Procédé selon la revendication 6 ou 7, dans lequel l'étape d'application est réalisée avant que les conducteurs (32) soient séparés d'une bande de trame de conducteurs continue.
